Europäisches Patentamt

European Patent Office

Office européen des brevets

(11) Veröffentlichungsnummer: **0 035 166**
A1

(12) **EUROPÄISCHE PATENTANMELDUNG**

(21) Anmeldenummer: 81101135.2

(22) Anmeldetag: 18.02.81

(51) Int. Cl.³: **H 04 B  1/26,** H 03 D  3/00

(30) Priorität: **01.03.80  DE 3007907**

(43) Veröffentlichungstag der Anmeldung: 09.09.81
**Patentblatt 81/36**

(84) Benannte Vertragsstaaten: **AT BE CH DE FR GB IT LI LU NL SE**

(71) Anmelder: **Licentia Patent-Verwaltungs-GmbH, Theodor-Stern-Kai 1, D-6000 Frankfurt/Main 70 (DE)**

(72) Erfinder: **Schaller, Wolfgang, Dr.-Ing., Am Roten Berg 51, D-7900 Ulm (DE)**

(74) Vertreter: **Langer, Karl-Heinz, Dipl.-Ing. et al, Licentia Patent-Verwaltungs-GmbH Theodor-Stern-Kai 1, D-6000 Frankfurt/Main 70 (DE)**

(54) **Digitaler Empfänger.**

㊷  Es wird ein voll digitalisierter Empfänger mit Oszillator (2), Mischer (1), ZF-Filter (3) und Demodulator (Demod.) beschrieben, welcher im Quadratursystem arbeitet. Die Oszillatorfrequenz ist gleich der Empfangsfrequenz gewählt. Alle Einheiten haben eigene, teilweise vielfache, Rechenwerke und Speichereinheiten. Die Tiefpaßeinheiten des ZF-Filters (3) bestehen aus der Hintereinanderschaltung eines transversalen (transv. TP) und eines rekursiven (rek. TP) Filters. Nach dem transversalen Filter wird die Abtastrate reduziert. Das transversale und/oder das rekursive Filter können auch aus mehreren Stufen bestehen mit jeweils abnehmender Abtastrate. Vorzugsweise weist das transversale Filter einen großen Formfaktor auf, während das rekursive Filter den endgültigen Formfaktor des ZF-Filters (2) festlegt. Der digitale Empfänger entspricht den Anforderungen nach Multiplikationsökonomie und Schleifenfreiheit in den zeitkritischen Prozessorteilen. Er ist bis zu Eingangsbandbreiten von 50 MHz geeignet, sobald eine Schaltenergie (speed-power-product) von 30 fJ machbar ist.

C035166

Licentia Patent-Verwaltungs-GmbH
Theodor-Stern-Kai 1
D-6000 Frankfurt 70

Ulm, 03.02.81
Z13-UL/Bl/sa
AZ.: P 30 07 907.3

Digitaler Empfänger

Die Erfindung betrifft einen digitalen Empfänger nach dem Oberbegriff des Anspruchs 1. Ein solcher Empfänger ist aus der US-PS 40 90 145 bekannt.

Integrierte digitale Schaltkreise nähern sich derzeit einer Komplexität von $10^5$ Transistorfunktionen pro Chip. In absehbarer Zeit werden auch $10^6$ Transistorfunktionen pro Chip technologisch realisierbar sein. Parallel zu dieser Entwicklung nimmt die Schaltgeschwindigkeit ständig zu. Daher rücken digitalisierte Lösungen für hochfrequenztechnische Anwendungen in den Bereich des Möglichen. Sie haben gegenüber analogen Schaltungen den Vorteil der Integrierbarkeit und Programmierbarkeit.

Ein wesentlicher Baustein in allen hochfrequenztechnischen Geräten und Systemen ist der Empfänger. Der Empfänger verstärkt, filtert und demoduliert HF-Signale.

...

0035166

Die Breite des Empfangsbereichs der häufigsten Empfängertypen (Rundfunk, Sprechfunk, Tastfunk, Radar) hat eine
Größenordnung von einigen MHz bis zu einigen 10 MHz. Da
Computer bisher nur Signalbandbreiten von einigen kHz in
Realzeit verarbeiten können, erschien eine vollständige
Digitalisierung von HF-Empfängern bisher nicht möglich.

Aufgrund der eingangs genannten technologischen Fortschritte ist es allerdings nur noch eine Frage der Zeit,
daß ein digitaler Empfänger realisierbar wird. Die derzeitige Leistungslücke von 3 bis 4 Zehnerpotenzen wird
in zehn Jahren seitens der Technologie auf 2 bis 3 Zehnerpotenzen geschrumpft sein. In der Zwischenzeit gilt es
Strukturen zu entwickeln, die durch Spezialisierung eines
Computers auf den Anwendungsfall HF-Empfänger die verbleibende Lücke ganz schließen.

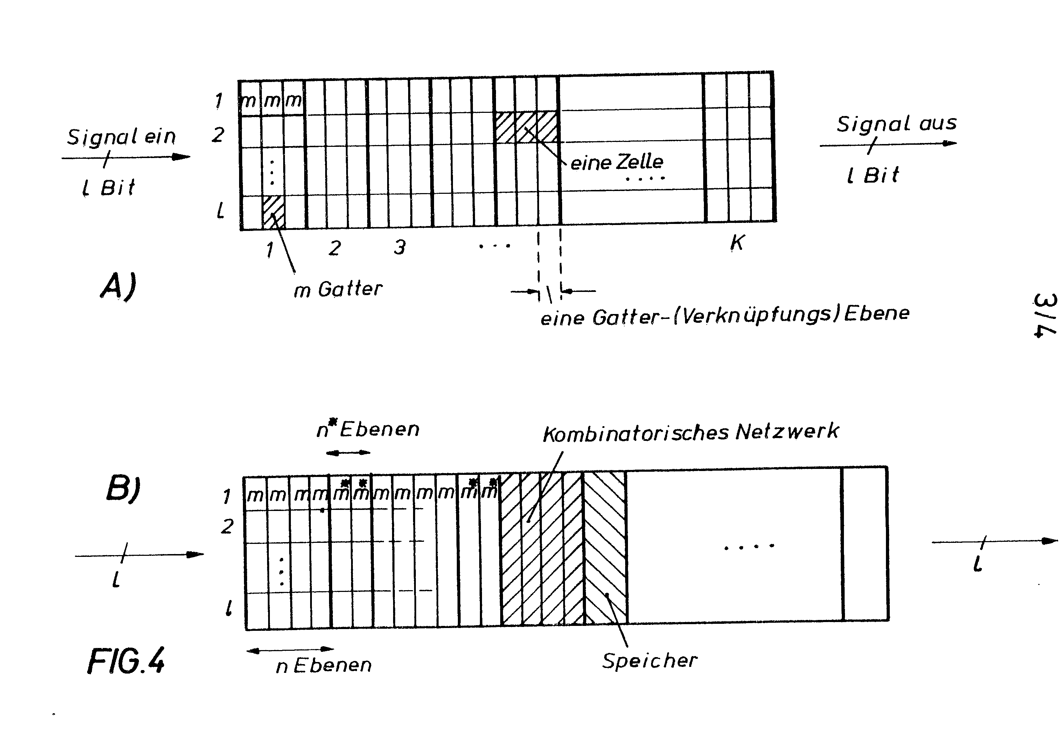

Die bereits erwähnte US-PS 40 90 145 beschreibt einen
Empfänger mit Quadratursystem, der Bandbreiten größer 10 MHz
verarbeiten soll. Der Schwerpunkt dieser Schrift liegt auf
der digitalen Demodulation hinter der Filterstufe. Bis einschließlich zur Filterung ist der Aufbau ansonsten noch in
analoger Bauart. Die Schrift gibt zwar in ihrer FIG. 4 bereits ein Blockschaltbild für einen voll digitalisierten
Quadraturempfänger an, ohne jedoch auf die Probleme und
Begrenzungen einzugehen, die durch die Technologie gegeben
sind. Insbesondere ist zwar von einem digitalen Tiefpaß die
Rede, aber nicht gesagt, wie dieser in Anbetracht der extremen Anforderungen geschaffen sein soll.

Schwerpunkt der vorliegenden Erfindung ist der Prozessorteil des digitalen Empfängers, d. h. die Signalverarbeitung zwischen Analog-Digital-Wandlung des Empfangssignals
und Digital-Analog-Wandlung des demodulierten Signals.

...

Der Prozessorteil des digitalen Empfängers wird in seiner Struktur durch zwei Anforderungen geprägt:

a) Die Zahl der Operationen muß minimal sein. Der zeitbestimmende Operationstyp ist die Multiplikation. Bei der digitalen Signalverarbeitung ist die Multiplikation sehr häufig. Sie bestimmt praktisch die Rechenzeit und den Aufwand. Daher sind Empfänger- bzw. Filterstrukturen zu suchen, die möglichst wenige Multiplikationen pro Abtastwert des Signals benötigen.

b) Die zeitkritischen Algorithmen dürfen keine Schleifen enthalten.

Der technologische Trend geht zu immer kleineren Abmessungen des einzelnen Gatters auf dem Chip. Die Leistungsfähigkeit der integrierten Schaltungen wächst also in erster Linie durch die Zahl der Gatter pro Chip und erst in zweiter Linie durch die Schaltgeschwindigkeit der Gatter. Deshalb wird ein zukünftiger digitaler Empfänger mit vielen parallelen Rechenwerken arbeiten müssen. Dadurch wird zwar die Durchsatzleistung erhöht, nicht aber die Durchsatzzeit vermindert. Schleifen oder Rückkopplungen in zeitkritischen Teilen des Prozessors verbieten sich aus diesem Grunde, denn sie erfordern eine begrenzte Durchlaufzeit. Damit ist es unmöglich, rückgekoppelte Systeme wie z. B. rekursive Filter stabil zu bekommen.

Aufgabe der Erfindung ist es, einen digitalen Empfänger der eingangs genannten Art anzugeben, welcher die vorgenannten Forderungen erfüllt.

Die Lösung dieser Aufgabe ist im Patentanspruch 1 beschrieben. Die Unteransprüche beinhalten vorteilhafte Weiterbil-

...

0035166

dungen bzw. Ausführungen der Erfindung.

Die Erfindung wird im folgenden in einer bevorzugten Ausführungsform näher beschrieben. Die Prozessorstruktur ist
bis zu Eingangsbandbreiten von 50 MHz entsprechend einer
Datenrate von 100 MWorte/sec geeignet, sobald eine Schaltenergie (speed-power-product) von 30 fJ machbar ist
(heute 300 fJ).

Der Prozessor besteht aus dem Mischer 1, gebildet aus den
zwei eingangsseitigen Multiplizierern $M_I$ und $M_Q$, dem Oszillator 2, gebildet aus Integrator Ingegr. und Sinus/Cosinustafel ROM, dem komplexen Kanalfilter 3 als Tiefpaß und der
Demodulatoreinheit Demod. Alle Einheiten haben eigene,
teilweise vielfache Rechenwerke. Das vom A/D-Wandler ADU
kommende reelle Signal wird mit einer komplexen Schwingung
aus dem Oszillator 2 gemischt. Dabei entsteht ein komplexes
(analytisches) Zwischenfrequenzsignal. Da die Oszillatorfrequenz f gleich der zu empfangenden Kanalfrequenz gewählt
wird, hat das ZF-Signal die Mittenfrequenz Null. Im Demodulator wird das analytische ZF-Signal x+jy wieder reell gemacht, womit eine Demodulation zwangsläufig verbunden ist.
Für Amplitudenmodulation bildet der Demodulator beispielsweise den Betrag $r = \sqrt{x^2+y^2}$.

Der Oszillator 2 wird vorzugsweise durch eine Rechenschaltung dargestellt, die synchron mit der Eingangsdatenrate
des Empfängers Sinus- und Cosinusabtastwerte liefert. Die
eingestellte Oszillatorfrequenz f liegt als konstanter Zahlenwert am Eingang des Integrators Integr. Sie wird in eine
fortlaufende Phase (2π f.t) modulo 2π umgewandelt und anschließend als Adresse in der festgespeicherten Sinus/Cosinustafel ROM verwendet. Um den Speicheraufwand zu begrenzen,
ist mit der Tafelanwendung in einer vorteilhaften Ausführungsform eine Interpolation verbunden.

...

0035166

Die Auslegung des digitalen Empfängers als Quadratursystem ist eine für die Ersparnis an Multiplikationen vorteilhafte Maßnahme. In einem Quadratursystem wird das Signal durch ein Wertepaar dargestellt - I-Kanal/Q-Kanal bzw. COS-Kanal/ SIN-Kanal - das als komplexer Wert verstanden werden kann.

Das vom A/D-Wandler ADU kommende Signal ist noch reell. Es wird erst durch Multiplikation mit dem komplexen Oszillatorsignal komplex. Das Mischprodukt ist im Gegensatz zu dem reeller Mischstufen eindeutig, d. h. ein Spiegelempfang läßt sich vermeiden. Daher kann die Oszillatorfrequenz auch innerhalb des Empfangsbandes liegen.

Bei reellen analogen Mischstufen in breitbandig abstimmbaren Empfängern muß man im Gegensatz dazu die Oszillatorfrequenz größer als die doppelte höchste Empfangsfrequenz wählen, um in Verbindung mit einer entsprechend hohen Zwischenfrequenz das Spiegelproblem zu umgehen. Damit ist eine Einsparung an benötigter Abtastrate von rund 50 % durch das Quadratursystem ersichtlich.

Proportional zur verminderten Abtastrate sinkt der Aufwand an Multiplikationen pro Zeiteinheit in Mischstufe 1 und ZF-Filter 3. Da diese aber zur Verarbeitung komplexer Signale zweikanalig ausgelegt sind, wird der Vorteil bis zu diesem Punkt der Betrachtung kompensiert.

Das ZF-Filter 3 ist ein Tiefpaß. Gegenüber einem Bandpaß wird nur ein halb so hoher Filtergrad für die gleiche Selektion benötigt. Außerdem kann die Filterausgangsabtastrate des Tiefpasses halb so hoch wie die eines entsprechenden Bandpasses sein, was für die erfindungsgemäße Realisierung mit Transversalfilter als erster Selektionsstufe den Aufwand abermals halbiert. Zusammengefaßt ergibt

...

C035166

sich also im Filter eine Aufwandsreduktion durch das Quadratursystem im Verhältnis 4 : 1.

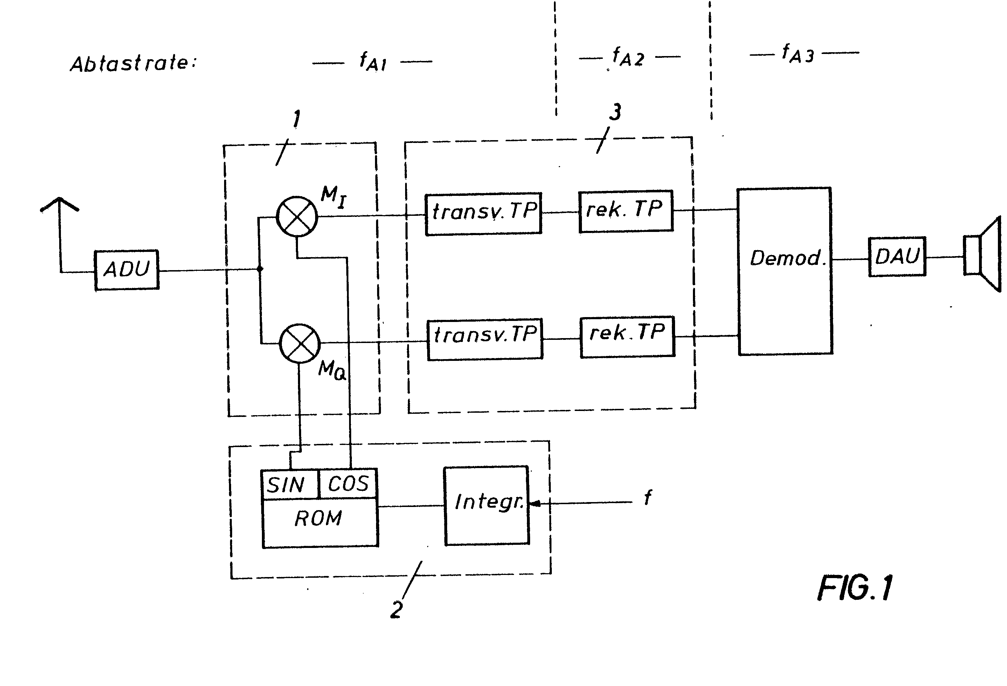

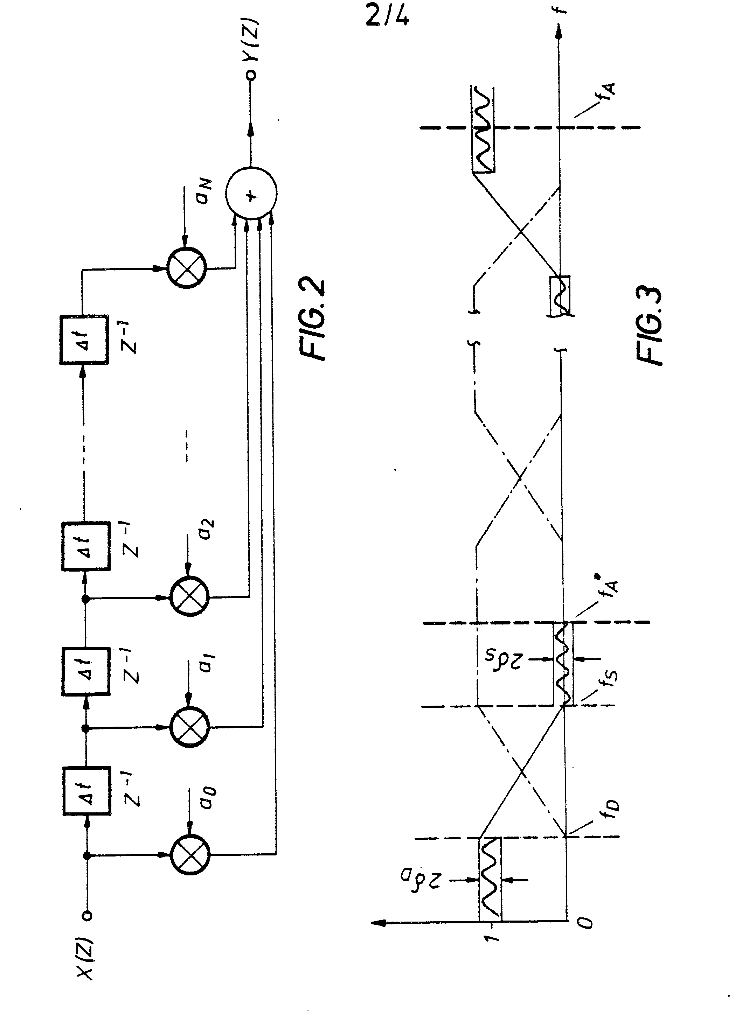

Transversalfilter, auch nichtrekursive Filter genannt, FIG. 2, enthalten keine Rückkopplungen. Sie erfüllen damit die gestellte Forderung nach Schleifenfreiheit. Sie haben die allgemeine Übertragungsfunktion

$$H(z) = \frac{y(z)}{x(z)} = a_o + a_1\, z^{-1} + a_2\, z^{-2} + \ldots a_N\, z^{-N}$$

$$= \frac{1}{z^N} \left( a_o\, z^N + a_1\, z^{N-1} + \ldots a_n\, z^o \right)$$

mit $x(z)$ = Eingangssignal, $y(z)$ = Ausgangssignal

$a_o \ldots a_N$ = Filterkoeffizienten, $N$ = Filtergrad.

Da sie, abgesehen von einem N-fachen Pol bei $z = 0$ nur Nullstellen besitzen, ist ein hoher Filtergrad N nötig, um einen ausgedehnten Sperrbereich zu erzeugen. Der Aufwand an Multiplikationen ist demnach hoch, was im allgemeinen zu einer Bevorzugung der rekursiven Filter gegenüber den nichtrekursiven Filtern führt.

Wird jedoch in einem System die Abtastrate nach der Filterung (Tiefpaß, Bandpaß) reduziert, was ja wegen der mit der Filterung verbundenen Bandbreitereduzierung möglich und zweckmäßig ist, dann wird das Transversalfilter wieder attraktiv. Wegen fehlender Rückkopplungen braucht der Filterzustand nicht für jeden am Eingang neu zugehenden Abtastwert berechnet zu werden. Es genügt, die Rechnung

...

einmal pro verbleibendem Ausgangswert, entsprechend der reduzierten Abtastrate, durchzuführen. Die Ersparnis entspricht dem Reduktionsfaktor in der Abtastrate.

Die Zahl der benötigten Multiplikationen pro Abtastwert ist für das Transversalfilter ohne Abtastratenreduktion gleich dem Filtergrad N. Das Übertragungsverhalten des Filters (Tiefpaß) ist gemäß FIG. 3 gekennzeichnet durch Durchlaßfrequenz $f_D$, Sperrfrequenz $f_S$, Durchlaßwelligkeit $\delta_D$ und Sperrwelligkeit $\delta_S$. Die folgende Tabelle gibt den Multiplizieraufwand M für ein Filter mit den Welligkeiten $\delta_D = 5\ \%$ und $\delta_S = 10^{-5}$ (-100 dB) an.

| $f_S/f_D:$ | 2 | 5 | 10 | 20 | 100 | $\infty$ |
|---|---|---|---|---|---|---|
| $M_{rekursiv}$ | 11 | 6 | 5 | 4 | 3 | 1 |
| $M_{transversal}$ | $6f_A/f_S$ | $3,8f_A/f_S$ | 3,3... | 3,2... | 3... | 3... |
| $M^*_{transversal}$ | 9 | 4,5 | 3,7 | 3,3 | 3 | 3 |

Beim Transversalfilter ist der Aufwand vom Verhältnis Sperrfrequenz $f_S$ zu Abtastfrequenz $f_A$ abhängig. Dabei ist noch keine Ratenreduktion zugrunde gelegt. Reduziert man aber gemäß FIG. 3 die ausgangsseitige Abtastrate und damit die Berechnungsrate auf den kleinsten zulässigen Wert $f^*_A = f_S + f_D$, dann erhält man einen Multiplizieraufwand $M^*$, der ebenso wie beim rekursiven Filter unabhängig von der

...

relativen Breite des Filters ist. Der Aufwand ist sogar, bis hin zu einem Formfaktor $f_S/f_D = 100$, geringer als beim rekursiven Filter.

Eine weitere Einsparungsmöglichkeit resultiert aus der Symmetrie der Filterkoeffizienten

$$a_i = a_{N-i} \qquad H(z) = \sum_{i=0}^{N/2} a_i(z^{-i} + z^{-N+i}),$$

wodurch sich die Zahl der Multiplikationen je eingangsseitigem Abtastwert noch einmal halbieren läßt.

Der Vorteil der Abtastratenreduktion läßt sich nur beim transversalen Filter voll realisieren, da im rekursiven Filter wegen der Rückkopplungen auch Zwischenwerte gebraucht werden.

Eine weitere Methode zur Aufwandsreduktion besteht darin, das gesamte Filter in mehrere Stufen mit abnehmender Abtastrate aufzuspalten. Da die Signalbandbreite von Stufe zu Stufe kleiner wird, darf die Abtastrate entsprechend verringert werden. Das hat den auch mit rekursiven Filtern zu realisierenden Vorteil, daß die hinteren Stufen weniger Rechenleistung benötigen.

Das theoretische Optimum liegt bei sehr großer Stufenzahl. Aus praktischen Gründen wird man aber kaum über 2 bis 3 Stufen hinausgehen, denn der weiter erzielbare Gewinn wird immer geringer. Nach dem anfangs Gesagten müßten die Filterstufen transversale Struktur haben. Man entfernt sich jedoch nicht viel weiter vom Optimum, wenn man nur die erste(n) Stufe(n) transversal wählt und als letzte Stufe(n) die flexibleren rekursiven Filter wählt. Besonders für sehr

...

große Verhältnisse von Eingangs- zu Ausgangsbandbreite des gesamten Filters erspart man sich so einen unpraktisch großen Koeffizientenspeicher. Es sei auch nicht verschwiegen, daß Transversalfilter sehr hohen Grades erhebliche Schwierigkeit der Berechnung zeigen.

Das transversale Filter wird als erste Selektionsstufe nach dem Mischer verwendet. Der Formfaktor wird vorzugsweise so groß gewählt, daß nur ca. 1,5 Multiplikationen je Abtastwert erforderlich sind. Der endgültige Formfaktor der ZF-Selektion wird dann in der zweiten Selektionsstufe bei erheblich niedrigerer Abtastrate mit einem rekursiven Filter realisiert. Wegen der größeren zur Verfügung stehenden Berechnungszeitdauer sind hier Schleifen nicht mehr unzulässig, so daß der Vorteil des rekursiven Filters, mit einer niedrigeren Zahl N von abzuspeichernden Koeffizienten auszukommen, nutzbar wird. Mit dieser Lösung ist der Gesamtaufwand gegenüber einer einstufigen Lösung um eine Größenordnung niedriger. Aus Gründen der Multiplikationsökonomie sollte das rekursive Filter vom Tschebyschefftyp sein.

Der arithmetische Aufwand von ca. $10^9$ Multiplikationen/sec für den digitalen Empfänger erfordert einen hohen Grad von Parallelität bei den Rechenwerken. Es sind größenordnungsmäßig 10 Multiplizierer nötig, die in sich weiterhin parallel strukturiert sind. Sie besitzen für alle Unteroperationen (Additionen) separate Verknüpfungsschaltungen, die gleichzeitig arbeiten.

Es stellt sich die Frage nach der optimalen Parallelstruktur der Rechenwerke hinsichtlich des Produktes Gatterzahl x Operationszeit, das minimiert werden soll. Eine integrations-

...

C035166

freundliche Form des Parallelmultiplizierers ist die Matrixform (iterative array). Die Matrix besitzt k . l identische Zellen und bildet damit das Produkt aus zwei Operanden, deren Wortlänge k bzw. l beträgt. Für das Signal ist der Multiplizierer ein kombinatorisches Netzwerk mit vielen Stufen, also Verknüpfungsebenen, das durchlaufen werden muß, vgl. FIG. 4A. Die Durchsatzleistung dieses Netzwerks kann erhöht werden, indem man in gewissen Abständen Speicherebenen einfügt. Dann kann nämlich ein neuer Wert schon an den Eingang des Netzwerks gelegt werden, ehe der alte alle Stufen durchlaufen hat. Eine solche Anordnung wird als Fließbandstruktur (pipelining) bezeichnet (FIG. 4B).

Es ist sinnvoll, nach dem optimalen Abstand der Speicher zu fragen, denn zu viele Speicherebenen würden wegen des zusätzlichen Aufwandes und der zusätzlichen Laufzeit das Verhältnis aus Durchsatzleistung und Gatterzahl wieder verschlechtern.

Die Zahl der Verknüpfungsebenen pro Speicherebene sei n. Damit ist die Laufzeit von Speicher zu Speicher gleich n-mal der Gatterlaufzeit zuzüglich der Speicherlaufzeit $(n^*)$.

Der Gatteraufwand pro Bit des hindurchlaufenden Signals sei m pro Verknüpfungsebene und $m^*$ pro Speicher (FIG. 4). Dann gilt für das Aufwand-Laufzeit-Produkt pro Verknüpfungsebene

$$(n \cdot m + m^*)(n + n^*) / n \longrightarrow \text{Min}$$

$$m - m^* n^* / n^2 = 0$$

$$n_{opt} = \sqrt{n^* m^* / m}$$

...

Es existiert also eine optimale Konfiguration aus verteilter Verknüpfung- und Speicherlogik, die die beste
Schaltungsausnützung bringt. An einem Beispiel sei der
Vorteil der Fließbandstruktur belegt:

Ein Multiplizierer für 16 x 16 Bit benötigt in rein kombinatorischer Logik ca. 2000 Gatter in mindestens 32 Ebenen. Der Parameter m beträgt damit rund 4 (Gatter pro Bit
pro Ebene) und es ergibt sich als optimaler Abstand der
Speicherebenen

$$n_{opt} \approx 2,$$

wenn man einmal $m^{*}$ = 6 Gatter pro Speicherbit und $n^{*}$ = 3
Elementarlaufzeiten für die Speicherebene ansetzt. Die
resultierende spezifische Leistung des Multiplizierers
ist hier viermal größer als ohne eingefügte Speicher.
(Die Durchlaufzeit erhöht sich zwar um 150 % und der
Schaltungsaufwand um 75 %, aber die Durchsatzrate steigt
dafür auf das 7-fache an).

Der große Vorteil einer digitalen Lösung für den Funkempfänger ist außer der Integrierbarkeit die einfache
Möglichkeit einer Programmierung. Damit kann der gleiche
Schaltkreis für eine Vielzahl von Einsatzfällen Verwendung
finden, wodurch seine rationelle Fertigung ermöglicht wird.

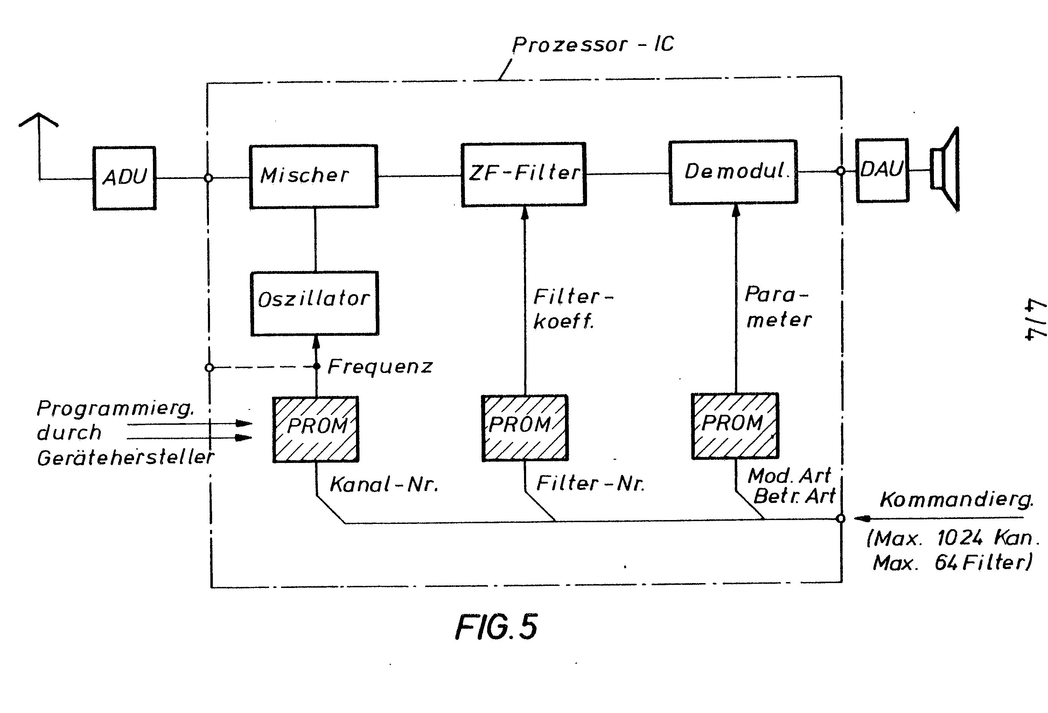

FIG. 5 zeigt das Prinzip der Programmierung. Es sind zwei
Ebenen zu unterscheiden. Die innere Programmierung wird vom
Gerätehersteller vorgenommen. Er lädt die PROM-Speicher für
den vorgesehenen Anwendungsbereich des Empfängers. Es können viele Filterkurven und Demodulationsarten in Gestalt von
Parametersätzen (Filterkoeffizienten etc.) gleichzeitig gespeichert werden. Für Funkgeräte mit einem festen Kanalraster können alle erforderlichen Kanalabstimmungen fest

...

0035166

gespeichert werden. Mit einer projektierten PROM-Speichergröße von insgesamt 30 ... 1000 KBit können Tausende von Kanalfrequenzen und Dutzende von Filterkurven und Modulations/Betriebsarten gleichzeitig eingespeichert werden.

Die zweite Programmierebene ist die des Geräteanwenders, in FIG. 5 außerhalb der strichpunktierten Linie mit Kommandierung bezeichnet. Er bedient den digitalen Empfänger über Kommandos und ruft damit die gewünschten Programme, also Funktionen, ab. Im einfachsten Fall kann das über Schalter und Drehknöpfe erfolgen. Bei komplexeren Empfängern wird die Kommandierung über eine Tastatur zweckmäßig sein. In rechnergesteuerten Systemen ist die direkte Fernsteuerung des digitalen Empfängers ohne Zwischenschaltung einer aufwendigen Anpaßeinheit möglich.

- 13 -

Licentia Patent-Verwaltungs-GmbH
Theodor-Stern-Kai 1
D-6000 Frankfurt 70

Ulm, 03.02.81
Z13-UL/Bl/sa

AZ.: P 30 07 907.3

Auslandsfassung

Patentansprüche

1. Digitaler Empfänger mit einem Oszillator, einem Mischer, einem ZF-Filter und einem Demodulator, wobei

- ein Analog-Digital-Wandler (ADU) das Empfangssignal wandelt und es dem Mischer (1) zuführt, welcher aus zwei parallel arbeitenden Multiplizierern ($M_I$ und $M_Q$) besteht;

- der Oszillator (2) ein Quadratursignal abgibt;

- die Oszillatorfrequenz (f) gleich der Empfangsfrequenz gewählt ist

- das ZF-Filter (3) aus zwei parallel arbeitenden Tiefpaßeinheiten (TP) besteht;

- im Demodulator (Demod.) die parallel verarbeitenden Signale zur Bildung der Phase oder Amplitude verknüpft werden und

. . .

- einem Digital-Analog-Wandler (DAU) zugeführt werden;

gekennzeichnet durch folgende Merkmale:

- der Mischer (1), der Oszillator (2), das ZF-Filter (3) und der Demodulator (Demod.) haben jeweils eigene, teilweise vielfache, Rechenwerke und Speichereinheiten;

- die Tiefpaßeinheiten des ZF-Filters (3) bestehen aus der Hintereinanderschaltung eines transversalen (transv. TP) und eines rekursiven (rek. TP) Filters;

- nach dem transversalen Filter (transv. TP) wird die Abtastrate reduziert (FIG. 1).

2. Digitaler Empfänger nach Anspruch 1, gekennzeichnet durch folgende Merkmale:

Der Oszillator (2) besteht aus einem Integrator (Integr.) und einer festgespeicherten Sinus/Cosinustafel (ROM). Die eingestellte Oszillatorfrequenz (f) liegt als konstanter Zahlenwert am Eingang des Integrators (Integr.), wird in diesem in eine fortlaufende Phase umgewandelt und anschließend als Adresse an die Sinus/Cosinustafel (ROM) gegeben. Letztere gibt an die Multiplizierer ($M_I$ und $M_Q$) Cosinus- bzw. Sinus-Abtastwerte ab.

3. Digitaler Empfänger nach Anspruch 2, dadurch gekennzeichnet, daß die Sinus/Cosinustafel (ROM) einen Interpolator aufweist.

4. Digitaler Empfänger nach Anspruch 1, dadurch gekennzeichnet, daß das transversale und/oder das rekursive Filter aus mehreren Stufen besteht mit jeweils abnehmender Abtastrate.

...

0035166

5. Digitaler Empfänger nach Anspruch 1, dadurch gekennzeichnet, daß das rekursive Filter (rek. TP) vom Tschebyschefftyp ist.

6. Digitaler Empfänger nach einem der Ansprüche 1 bis 5, dadurch gekennzeichnet, daß das transversale Filter (transv. TP) einen großen Formfaktor aufweist, und daß das rekursive Filter (rek. TP) den endgültigen Formfaktor des ZF-Filters (2) festlegt.

7. Digitaler Empfänger nach einem der vorhergehenden Ansprüche, dadurch gekennzeichnet, daß die Rechenwerke Fließbandstruktur aufweisen.

...

Abtastrate: — $f_{A1}$ — — $f_{A2}$ — — $f_{A3}$ —

FIG.1

C035166

1/4

FIG.2

FIG.3

**A)**

Signal ein → $l$ Bit

Signal aus → $l$ Bit

eine Zelle

$m$ Gatter

eine Gatter-(Verknüpfungs)Ebene

**B)**

$n^*$ Ebenen

Kombinatorisches Netzwerk

Speicher

$n$ Ebenen

FIG.4

Prozessor – IC

FIG.5

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| D | US - A - 4 090 145 (WEBB)<br><br>* Spalte 6, Zeile 52 bis Spalte 7, Zeile 41; Abbildung 4; Spalte 9, Zeile 36 bis Spalte 10, Zeile 5 *<br><br>--- | 1,2,7 |
| | DE - A - 2 628 472 (AERONUTRONIC FORD CORP.)<br><br>* Seite 6, Zeile 20 bis Seite 9, Zeile 14; Abbildung 1 *<br><br>--- | 1,2 |
| | US - A - 3 971 996 (MOTLEY)<br><br>* Spalte 8, Zeile 41 bis Spalte 10, Zeile 40; Abbildung 3 *<br><br>--- | 1,2 |
| | DE - B - 1 616 439 (IBM)<br><br>* Spalte 2, Zeilen 15-58; Spalte 8, Zeile 3 bis Spalte 13, Zeile 10; Abbildungen 5-7 *<br><br>--- | 1 |
| | TELECOMMUNICATION AND RADIO ENGINEERING, Band 32/33, Heft 5, 1978,<br>WASHINGTON (US)<br>POBEREZHSKIY: "Digital Short-Wave Radio Receivers", Seiten 72,78<br><br>* Seite 72, Zeile 1 bis Seite 73, Zeile 31 *<br><br>--- | 1 |
| | DE - A - 2 556 353 (N.V. PHILIPS' GLOEILAMPENFABRIEKEN)<br><br>* Seite 10, Zeile 4.bis Seite 14, Zeile 28 *<br><br>--- | 1,6 |

./..

**KLASSIFIKATION DER ANMELDUNG (Int. Cl.³)**

H 04 B 1/26
H 03 D 3/00

**RECHERCHIERTE SACHGEBIETE (Int. Cl.³)**

H 04 B 1/06
1/16
1/26
1/28
H 03 D 1/24
3/00
3/02
7/00
H 04 L 27/22
H 03 H 17/04
17/06

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 08.04.1981 | YOULE |

EPA form 1503.1   06.78

EPA Form 1503.2   06.78

| EINSCHLÄGIGE DOKUMENTE | | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | DE - A - 2 554 562 (N.V. PHILIPS' GLOEILAMPENFABRIEKEN)<br><br>* Patentanspruch 1; Abbildungen 1 und 4 *<br><br>---- | 1 | |
| | IEEE TRANSACTIONS ON ACOUSTICS SPEECH, AND SIGNAL PROCESSING, Band ASSP-23, Heft 5, Oktober 1975, NEW YORK (US) RABINER: "A Novel Implementation for Narrow-Band FIR Digital Filters, Seiten 457-464<br><br>* Seite 457; Zusammenfassung; Seite 457, linke Spalte, Zeile 1 bis rechte Spalte, Zeile 33; Seite 459, rechte Spalte, Zeile 22 bis Seite 460, linke Spalte, Zeile 2; Abbildungen 2 und 5 *<br><br>---- | 4 | RECHERCHIERTE SACHGEBIETE (Int. Cl. 3) |
| | ELECTRONICS LETTERS, Band 3, Heft 3, 1967, LONDON (GB) CONSTANTINIDES: "Synthesis of Chebychev Digital Filters", Seiten 124-126<br><br>* Insgesamt *<br><br>---- | 5 | |
| A | PHILIPS TELECOMMUNICATION REVIEW, Band 37, Heft 1, Mai 1979, HILVERSUM (NL) BIKKER: "A Microprocessor - Controlled Communications Receiver", Seiten 1-10<br><br>* Seite 3, Abbildung 2; Seite 5, Abbildung 4 *<br><br>------------ | | |